# EUROPEAN PATENT SPECIFICATION

(11) **EP 3 319 406 B1**
(45) Date of publication and mention of the grant of the patent: **23.09.2020**
(21) Application number: 16002324.8
(22) Date of filing: 02.11.2016
(51) Int. Cl.: H05K 5/00, B60R 16/023, H01R 13/52

(54) **CLOSING SYSTEM FOR DUST COVER**
SCHLIESSSYSTEM FÜR STAUBSCHUTZABDECKUNG
SYSTÈME DE FERMETURE POUR COUVERCLE ANTIPOUSSIÈRE

(43) Date of publication of application: 09.05.2018
(73) Proprietor: WABCO Europe BVBA, 1170 Brüssel (BE)
(72) Inventor: Nowicki, Michal, 54-610 Wroclaw (PL); Wojciechowski, Tomasz, 54-129 Wroclaw (PL); Wolanski, Michal, 54-129 Wroclaw (PL)
(74) Representative: Lauerwald, Jörg

(56) References cited:
- EP-A1- 0 778 180
- EP-A1- 0 859 442
- DE-A1- 3 514 440
- DE-A1- 19 934 189
- JP-A- 2012 105 494

## Description

The invention relates to a housing for an electronic control unit (ECU) of a vehicle, the housing comprising: a base body for attachment to a fixing portion of a vehicle and defining at least one receiving portion for receiving an electrical connector for connection with an ECU; a dust cover for covering the receiving portion, the dust cover being hingedly connected to the base body, such that the dust cover is pivotable to a first position, in which the dust cover covers the receiving portion and a second position, in which the receiving portion is accessible; and first and second corresponding engagement sections, engaging with each other, when the dust cover is in the first position for holding the dust cover in the first position.

Housings for electronic control units are for example known from the DE 35 14 440 A1 or JP 2012 105494 A.

In vehicles, in particular passenger vehicles and trucks, such electronic control units are used, to control operation and parameters of the combustion engine. The ECUs themselves are provided with a casing, and comprise electrical connector ports, for receiving connectors which connect the engine, in particular features of the engine, such as a common rail or the like, via a wired connection with the ECU. The ECU therefore is mounted in the engine region or in any other region in the vehicle, however needs to be accessible for service reasons. Therefore, the ECU is provided with a housing which covers the ECU and protects the ECU from environmental impacts. For protecting the connectors, in many cases a dust cover is provided which additionally covers the connectors. Such a dust cover is removably connected to the base body of the housing which is fixedly connected with the vehicle structure.

For connecting the cover with the base body, first and second corresponding engagement sections are provided, wherein the first engagement section is provided at the cover and the second engagement section is provided at the base body. The engagement sections correspond to each other, such that engagement between the cover and the base body is achieved. The engagement between the cover and the base body is manually operable, such that by manual, in particular tool-free operation, the cover and the base body are disengageable.

Additionally, the cover is connected to the base body by a hinged connection, such that the cover simply can be pivoted, for allowing access to the connectors. A problem associated with known housing having such a base body and a cover is that there are still gaps between the cover and the base body when in closed position and during closing which often is related to a falsely closing and incorrect engagement of the first and second engagement sections. This might be based on the position of the ECU which is often mounted in a region hard to reach for a service personal.

Therefore, it is an object of the present invention to provide a housing for an electronic control unit (ECU) of the aforementioned type, in which closing of the cover is simplified for providing a safe engagement of the first and second engagement sections.

According to a first aspect of the invention, this problem is solved by a housing of the aforementioned type which comprises a guiding mechanism for providing lateral guidance of the dust cover at least along a portion of the movement when the dust cover is moved from the second to the first position.

The invention is based on the idea that such a guiding mechanism helps to guide the dust cover while moving it to the first position which is the closing position. Normally, the housing, i.e. the base body and the dust cover, are formed out of a plastic material, and therefore, the cover is not totally stiff. Much more it is bendable and twistable and therefore closing the dust cover and engaging the first and second engagement section might be difficult for a service person. The guiding mechanism of the present invention provides lateral guidance, when closing the dust cover. The lateral guidance helps to keep the dust cover in a stable manner without bending and twisting it too much, such that engagement of the first and second engagement sections is simply feasible.

Preferably, the guiding mechanism is formed at the engagement sections, or the engagement section comprises the guiding mechanism. This helps to guide the dust cover in the area where guidance is needed. The dust cover preferably comprises first and second lateral side walls, a front wall and a top wall, the hinge being at the top wall. There is substantially no bottom wall, or an intersected bottom wall, such that cables from the connectors can pass through the housing and can be guided out of the housing. Since there is no bottom wall, stability of the dust cover in normal conditions is poor and the guiding mechanism helps to guide the instable dust cover. The cables are normally guided out of the housing at the bottom section of the dust cover, while the base body forms a rear wall of the housing. Guiding the cables out of the bottom portion helps to protect the ECU from environmental impacts. When the hinge is formed at the top wall, the dust cover can pivot upwards for providing access to the connectors. The engagement section of the dust cover preferably is formed at the side walls adjacent to the bottom portion of the dust cover, thus distal to the hinge, for providing a stable engagement. The engagement section may comprise a formfitting engagement which is durable during normal operation of the vehicle.

According to a first preferred embodiment of the invention, the guiding mechanism comprises a protrusion formed at the first engagement section which slides along a recess of the second engagement section for guiding the dust cover. Preferably, first and second protrusions are formed on both sides, thus close or adjacent to sidewalls of the dust cover. The protrusion might be formed as a pin, or a latch, which is guided along the recess of the second engagement section. The recess can be formed as a groove, or notch or the like or as an open recess, comprising a guiding wall. The idea is that the protrusion, in particular pin or latch, first comes into contact with the respective recess for being guided thereat, before the cover is in the first position. Thus, first, the protrusion comes into contact with a respective recess, and guides the cover at least in the last portion of the movement from the second to the first position, so that the cover is safely received in the first position.

Preferably, the guiding mechanism comprises first and second abutments which abut against each other, when the dust cover is in the first position. Preferably, a first abutment is formed at the first engagement section and a second abutment is formed at the second engagement section. The abutments help to define the end position in the first position and thus "overdosing" of the dust cover is prevented. The dust cover cannot be moved further than the first position and pushed too far against the base body which would result in a falsely closing. The abutments give a person a correct feedback, when the dust cover arrives in the first position.

According to a further preferred embodiment, the protrusion comprises a notch and a stop is arranged at the recess, such that the stop engages the notch when the dust cover is in the first position. Thus, the stop engages the notch in the first position and forms a mechanism similar to a "click mechanism". Preferably, the stop snaps into the notch under emitting a sound, such that a service person can check via hearing the sound that the dust cover is in the first position and thus correctly closed. Before snapping into the notch, the protrusion preferably is slightly deflected and snaps back, when the protrusion is in a position, where the stop can engage the notch. Thus, the service person needs to provide a bit of a pressure when closing the dust cover for deflecting the protrusion, such that the snap connection is obtained.

According to a further preferred development, the protrusion comprises a cam surface for contacting the stop and guiding the stop to the notch when the dust cover is moved from the second to the first position. The cam surface acts to displace the protrusion and guide the stop into the notch. The cam surface preferably is inclined with respect to a direction of movement of the protrusion when moving the cover from the second to the first position. The cam surface can be formed as a wedge-shaped portion of the protrusion.

Preferably, the notch opens generally into a direction of the hinge. Since the protrusion is slightly deflected and snaps back when the stop is in the region of the notch, the protrusion according to this embodiment is slightly biased away from the hinge, thus providing a tension force to the cover. This also supports a stable engagement of the cover when the cover is in the first position. The cover is tensioned between the hinge and the protrusion of the engagement section.

Preferably, the protrusion is substantially formed as a flat latch. Such a latch can provide lateral closure of the dust cover and is simple to form when the cover is made from plastic material. Moreover, a latch can be simply guided in a recess and also does not occupy much space inside the housing which is beneficial in modern vehicles where space is always constrained.

Preferably, the protrusion is integrally formed with a sidewall of the dust cover. This moreover makes the manufacturing of the dust cover simple and also protects the latch from being broken.

According to a further preferred embodiment, the first abutment is formed by a pin. The pin can be integral with the protrusion, or formed adjacent to the protrusion. The pin preferably provides a defined abutment with the second abutment such that the first position is readily defined.

In a further preferred embodiment, the first engagement section is provided at the dust cover and the second engagement section is provided at the base portion. Thus, preferably the protrusion is formed at the dust cover and the recess is formed at the base body. This in particular makes the usage of the housing more simple. When the dust cover is in the second open position, there is no protrusion protruding from the base body and the protrusion of the engagement section is pivoted away from the base body.

Alternatively, it is also possible that the first engagement section is provided at the base body and the second engagement section is provided at the dust cover.

In the following the invention is described with respect to the accompanying drawings in which:
- Fig. 1: shows a perspective view of the housing with the dust cover in the first position;
- Fig. 2: shows a perspective view of the housing with a sidewall of the dust cover cut-off;
- Fig. 3: shows a detail view of the guiding mechanism in the first position;
- Fig. 4: shows the recess formed at the base body and
- Fig. 5: shows the protrusion formed at the dust cover.

A housing 1 for an electronic control unit (ECU) of a vehicle comprises a base body 2 and a dust cover 4. The base body 2 comprises a bottom surface 6 and a top surface 8. The bottom surface 6 covers the ECU and the top surface 8 is exposed to the outside. Moreover, the base body comprises fixing portions 10a, 10b, 10c, for screwing or bolting the base body against a vehicle structure.

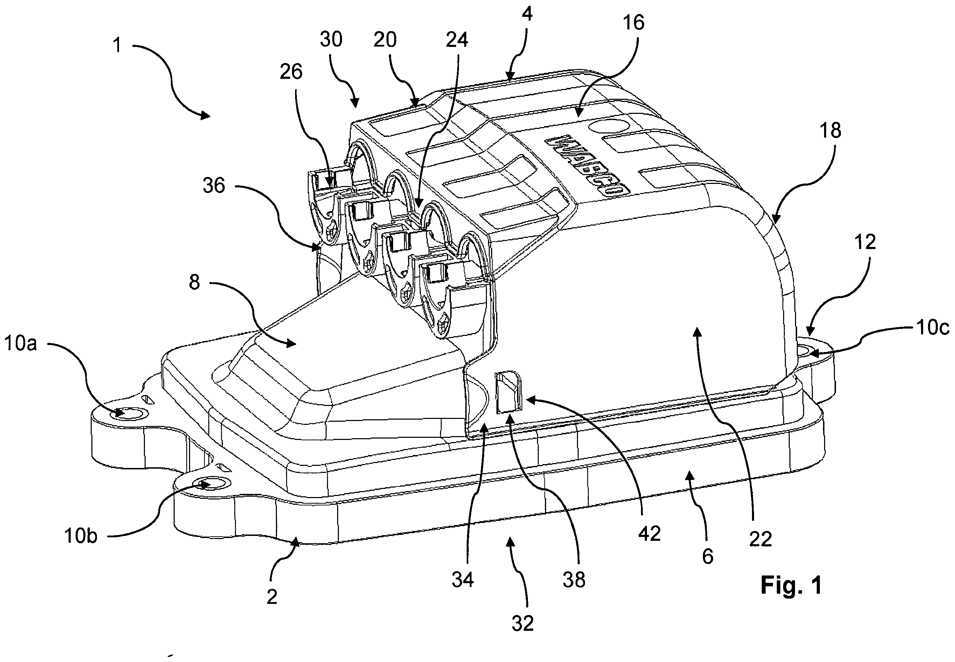

In the mounted position, the fixing portion 10c is at a top and the mounted portion 10a, 10b at the bottom. In normal conditions, the base body 2 will be fixed against the vehicle portion in a vertical manner, such that the bottom surface 6 is attached to a vertical surface having the ECU attached thereat. Otherwise, it is also possible to mount the housing 1 in a manner as shown in Fig. 1, thus with the bottom surface 6 mounted against a flat horizontal surface.

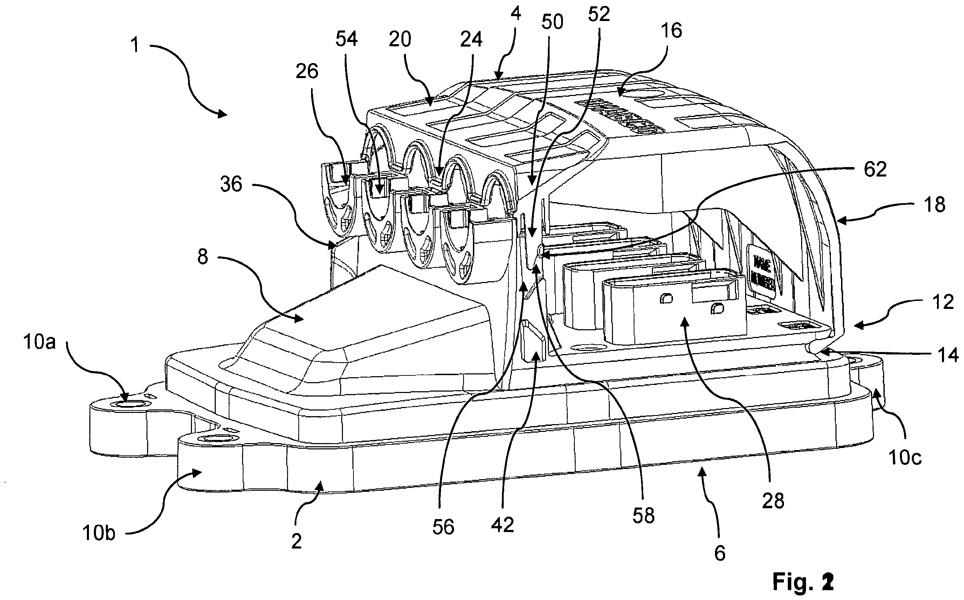

At a top portion 12 of the base body 2 the cover 4 is hingedly fixed by means of a pivot hinge 14 (see Fig. 2). The cover 4 comprises a front wall 16, a top wall 18, a left sidewall 20 and a right sidewall 22. The dust cover 4 does not comprise a bottom wall, it only comprises a tooth extension 24 which acts together with respective recesses 26 formed at the base body 2 for building cable passages out of the housing 1. The cable passages are usable for introducing four cables into the inside of the housing 1, for connectors 28 forming receiving portions (see Fig. 2).

The housing 1 moreover comprises a first engagement section 30 formed at the cover 4 and a second engagement section 32 formed at the base body. The first and second engagement sections 30, 32 act together to hold the dust cover 4 in the first position, the closed position, which is shown in Fig. 1.

As generally known, in the state of the art, the first and second engagement sections 30, 32 comprise side tabs 34, 36 at the sidewalls 20, 22 of the dust cover 4 which comprise through-holes 38, 40. The base body comprises corresponding knobs 42, 44 arranged for engaging the through-holes 38, 40, so that a form-locking connection between the dust cover 4 and the base body 2 is achieved. The knobs 42, 44 have a substantially rectangular form and extend straight out of the base body 2. For engaging and disengaging the cover 4 with the knobs 42, 44, the user has to grab the tabs 34, 36 and bend them slightly outwardly, so that the sidewalls 20, 22 of the dust cover 4 can be moved over the knobs 42, 44. When the dust cover 4 is in place, the user releases the tabs 34, 36 such that the knobs 42, 44 extend through the through-holes 38, 40.

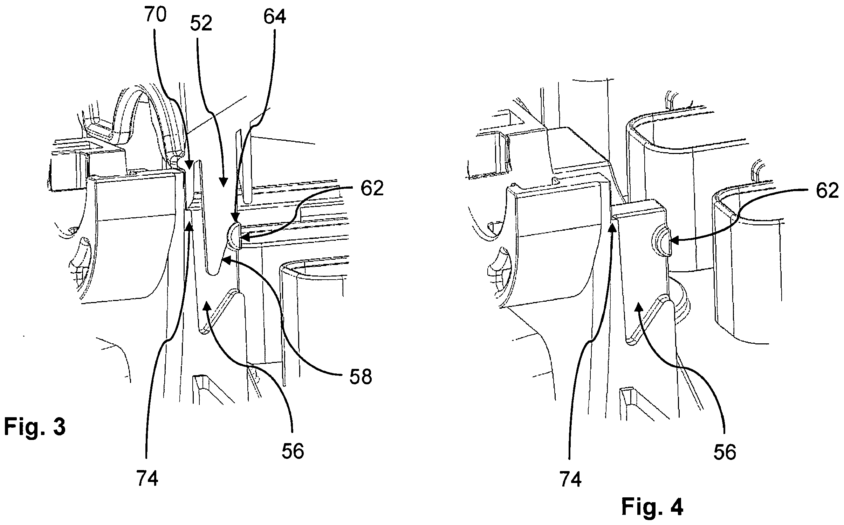

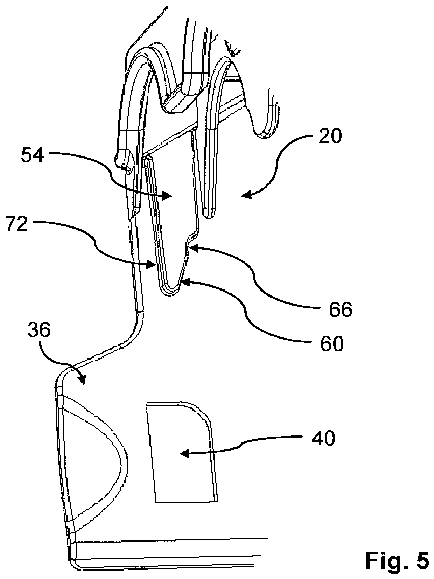

According to the present invention, the housing 1 comprises a guiding mechanism 50. The guiding mechanism 50 provides lateral guidance of the dust cover 4 along a portion of the movement when the dust cover 4 is moved from the second to the first position. According to the shown embodiment, the guiding mechanism 50 is formed at the bottom portion of the dust cover 4 and the corresponding portion of the base body 2. The guiding mechanism 50 comprises first and second protrusions 52, 54 which are guided in corresponding recesses 56 (in the figures only one shown). The recess 56 is formed at a side portion of the base body 2 and has a shape which substantially corresponds to the outer shape of the protrusion 52. The protrusion 52 is formed as a flat latch (see in particular Figs. 3 and 5). The latch 52, 54 has a cam surface 58, 60 (see Figs. 3 and 5) which is inclined and runs from a tip of the latch 52, 54 into the direction of the front wall 16. The cam surface 58, 60 acts as a guiding surface and comes into contact with the corresponding stop 62 (only one shown in the figures) which is provided inside the respective recess 56. The stop 62 has a round surface, for allowing sliding movement of the cam surface 58, 60 on a radial outer surface of the stop 62. The stop 62 corresponds to a notch 64, 66 and engages the notch 64, 66 when in the first position.

In Fig. 2 the cover 4 is in an intermediate position, in which the stop 62 is in contact with the cam surface 58, 60, however not yet engaged the respective notch 64, 66. When engaging the notch 64, 66, the latch 52, 54 snaps backwards, thus emitting a click sound which indicates to an operator that the dust cover 4 has readily approached the first position. In this position, the operator can release latches 34, 36 so that the knobs 42, 44 engage the through-holes 38, 40. The dust cover 4 is safely guided into this position by means of the protrusions 52, 54 which slide on surfaces of the recesses 56.

The guiding mechanism 50 moreover comprises a pin 70, 72 which forms a first abutment for abutting against a corresponding second abutment 74 (only one shown in the figures) of the base body 2. The pin 70, 72 is not deflected during closure of the dust cover 4 and simply abuts against the corresponding abutment 74 for defining an end position of the dust cover 4. The dust cover 4 thus cannot be moved further against the base body 2 which also helps to define the position, in which the user can disengage the tabs 34, 36, for engaging the tabs 34, 36 with the respective knobs 42, 44. Therefore, also the pin 70, 72 helps to guide and position the dust cover 4 during closure of the dust cover 4 and thus helps the user to easily close the dust cover 4.

## Claims

1. Housing (1) for an electronic control unit (ECU) of a vehicle, the housing comprising:
- a base body (2) for attachment to a fixing portion of a vehicle and defining at least one receiving portion (28) for receiving an electrical connector for connection with a ECU;
- a dust cover (4) for covering the receiving portion (28), the dust cover (4) being hingedly connected to the base body (2), such that the dust cover (4) is pivotable into a first position, in which the dust cover (4) covers the receiving portion (28) and a second position, in which the receiving portion (28) is accessible; and
first and second corresponding engagement sections (30, 32), engaging with each other, when the dust cover (4) is in the first position for holding the dust cover (4) in the first position,
**characterized by** a guiding mechanism (50) for providing lateral guidance of the dust cover (4) at least along a portion of the movement when the dust cover (4) is moved from the second to the first position.

2. Housing according to claim 1, wherein the guiding mechanism (50) comprises a protrusion (52, 54) formed at the first engagement section (30), which slides along a recess (56) of the second engagement section (32) for guiding the dust cover (4).

3. Housing according to claim 1 or 2, wherein the guiding mechanism (50) comprises first and second abutments (70, 72, 74), which abut against each other, when the dust cover (4) is in the first position.

4. Housing according to claim 2, wherein the protrusion comprises a notch (64, 66) and a stop (62) is arranged at the recess (56), such that the stop (62) engages the notch (64, 66) when the dust cover (4) is in the first position.

5. Housing according to claim 4, wherein the protrusion (52, 54) comprises a cam surface (58, 60) for contacting the stop (62) and guiding the stop (62) to the notch (64, 66) when the dust cover (4) is moved from the second to the first position.

6. Housing according to claim 4 or 5, wherein the notch (64, 66) opens generally into a direction of the hinge (14).

7. Housing according to claim 2, wherein the protrusion (52, 54) is substantially formed as a flat latch.

8. Housing according to claim 2, wherein the protrusion (52, 54) is integrally formed with a sidewall (20, 22) of the dust cover (4).

9. Housing according to claim 3, wherein the first abutment (70, 72) is formed by a pin.

10. Housing according to any of the preceding claims, wherein the first engagement section (30) is provided at the dust cover (4), and the second engagement section (32) is provided at the base body (2).

## Patentansprüche

1. Gehäuse (1) für eine elektronische Steuereinheit (ECU) eines Fahrzeugs, wobei das Gehäuse umfasst:
- einen Basiskörper (2) zur Befestigung an einem Fixierteil eines Fahrzeugs, und der mindestens ein Aufnahmeteil (28) zum Aufnehmen eines elektrischen Verbinders zum Verbinden mit einer ECU definiert;
- eine Staubschutzabdeckung (4) zum Abdecken des Aufnahmeteils (28), wobei die Staubschutzabdeckung (4) klappbar mit dem Basiskörper (2) verbunden ist, so dass die Staubschutzabdeckung (4) in eine erste Position, in welcher die Staubschutzabdeckung (4) das Aufnahmeteil (28) bedeckt, und eine zweite Position schwenkbar ist, in welcher das Aufnahmeteil (28) zugänglich ist; und
erste und zweite entsprechende Eingriffsegmente (30, 32), die miteinander in Eingriff sind, wenn die Staubschutzabdeckung (4) sich in der ersten Position befindet, um die Staubschutzabdeckung (4) in der ersten Position zu halten,
**gekennzeichnet durch** einen Führungsmechanismus (50) zum Bereitstellen von Seitenführung der Staubschutzabdeckung (4) mindestens entlang eines Teils der Bewegung, wenn die Staubschutzabdeckung (4) von der zweiten in die ersten Position bewegt wird.

2. Gehäuse nach Anspruch 1, wobei der Führungsmechanismus (50) einen Vorsprung (52, 54) umfasst, der an dem ersten Eingriffsegment (30) gebildet ist, welcher entlang einer Aussparung (56) des zweiten Eingriffsegments (32) gleitet, um die Staubschutzabdeckung (4) zu führen.

3. Gehäuse nach Anspruch 1 oder 2, wobei der Führungsmechanismus (50) erste und zweite Widerlager (70, 72, 74) umfasst, die aneinander stoßen, wenn sich die Staubschutzabdeckung (4) in der ersten Position befindet.

4. Gehäuse nach Anspruch 2, wobei der Vorsprung eine Kerbe (64, 66) umfasst, und ein Anschlag (62) an der Aussparung (56) angeordnet ist, so dass der Anschlag (62) in Eingriff mit der Kerbe (64, 66) kommt, wenn sich die Staubschutzabdeckung (4) in der ersten Position befindet.

5. Gehäuse nach Anspruch 4, wobei der Vorsprung (52, 54) eine Nockenoberfläche (58, 60) zum Kontaktieren des Anschlags (62) und Führen des Anschlags (62) zu der Kerbe (64, 66) umfasst, wenn die Staubschutzabdeckung (4) von der zweiten in die erste Position bewegt wird.

6. Gehäuse nach Anspruch 4 oder 5, wobei die Kerbe (64, 66) sich allgemein in eine Richtung des Scharniers (14) öffnet.

7. Gehäuse nach Anspruch 2, wobei der Vorsprung (52, 54) im Wesentlichen als flacher Riegel ausgebildet ist.

8. Gehäuse nach Anspruch 2, wobei der Vorsprung (52, 54) integral mit einer Seitenwand (20, 22) der Staubabdeckhaube (4) gebildet ist.

9. Gehäuse nach Anspruch 3, wobei das erste Widerlager (70, 72) durch eine Nadel gebildet ist.

10. Gehäuse nach einem der vorhergehenden Ansprüche, wobei das erste Eingriffsegment (30) an der Staubschutzabdeckung (4) bereitgestellt wird, und das zweite Eingriffsegment (32) an dem Basiskörper (2) bereitgestellt wird.

## Revendications

1. Boîtier (1) pour une unité de contrôle électronique (ECU) d'un véhicule, le boîtier comprenant :
- un corps de base (2) destiné à être attaché à une portion de fixation d'un véhicule et définissant au moins une portion de réception (28) destinée à recevoir un connecteur électrique destiné à être connecté avec une ECU ;
- un couvercle antipoussière (4) destiné à couvrir la portion de réception (28), le couvercle antipoussière (4) étant connecté par une charnière au corps de base (2), de telle sorte que le couvercle antipoussière (4) soit pivotable dans une première position, dans laquelle le couvercle antipoussière (4) couvre la portion de réception (28), et une deuxième position, dans laquelle la portion de réception (28) est accessible ; et
des première et deuxième sections d'entrée en prise correspondantes (30, 32), entrant en prise l'une avec l'autre, lorsque le couvercle antipoussière (4) est dans la première position pour maintenir le couvercle antipoussière (4) dans la première position,
**caractérisé par** un mécanisme de guidage (50) destiné à fournir un guidage latéral du couvercle antipoussière (4) au moins le long d'une portion du mouvement lorsque le couvercle antipoussière (4) est déplacé de la deuxième à la première position.

2. Boîtier selon la revendication 1, dans lequel le mécanisme de guidage (50) comprend une protubérance (52, 54) formée au niveau de la première section d'entrée en prise (30), qui coulisse le long d'un retrait (56) de la deuxième section d'entrée en prise (32) pour guider le couvercle antipoussière (4).

3. Boîtier selon la revendication 1 ou 2, dans lequel le mécanisme de guidage (50) comprend des première et deuxième butées (70, 72, 74), qui butent les unes contre les autres lorsque le couvercle antipoussière (4) est dans la première position.

4. Boîtier selon la revendication 2, dans lequel la protubérance comprend une entaille (64, 66) et un arrêt (62) est agencé au niveau du retrait (56), de telle sorte que l'arrêt (62) entre en prise avec l'entaille (64, 66) lorsque le couvercle antipoussière (4) est dans la première position.

5. Boîtier selon la revendication 4, dans lequel la protubérance (52, 54) comprend une surface de came (58, 60) destinée à rentrer en contact avec l'arrêt (62) et à guider l'arrêt (62) vers l'entaille (64, 66) lorsque le couvercle antipoussière (4) est déplacé de la deuxième à la première position.

6. Boîtier selon la revendication 4 ou 5, dans lequel l'entaile (64, 66) s'ouvre généralement dans une direction de la charnière (14).

7. Boîtier selon la revendication 2, dans lequel la protubérance (52, 54) est essentiellement formée sous la forme d'un loquet plat.

8. Boîtier selon la revendication 2, dans lequel la protubérance (52, 54) est formée d'un seul tenant avec une paroi latérale (20, 22) du couvercle antipoussière (4) .

9. Boîtier selon la revendication 3, dans lequel la première butée (70, 72) est formée par une goupille.

10. Boîtier selon l'une quelconque des revendications précédentes, dans lequel la première section d'entrée en prise (30) est disposée au niveau du couvercle antipoussière (4), et la deuxième section d'entrée en prise (32) est disposée au niveau du corps de base (2).
